Europäisches Patentamt

European Patent Office

Office européen des brevets

(11) Publication number: **0 165 036**
**B1**

(12) **EUROPEAN PATENT SPECIFICATION**

(45) Date of publication of patent specification: **03.10.90**

(21) Application number: **85304098.8**

(22) Date of filing: **10.06.85**

(51) Int. Cl.⁵: **G 01 R 13/00,** G 01 R 13/22, G 01 R 13/34

(54) A combined information recording and graphic display device.

(30) Priority: **08.06.84 GB 8414743**

(43) Date of publication of application:
**18.12.85 Bulletin 85/51**

(45) Publication of the grant of the patent:
**03.10.90 Bulletin 90/40**

(84) Designated Contracting States:
**AT BE CH DE FR GB IT LI LU NL SE**

(56) References cited:
**EP-A-0 066 843**
**US-A-3 652 999**

**NEW ELECTRONICS, vol. 15, no. 7, April 1982, pages 24,26, London, GB; I. SHANKS: "L.c.d screens: a leap forward"**

**DISPLAYS, vol. 3, no. 3, July 1982, pages 158-159, Guildford, Surrey, GB; "Displays news: More scope with liquid crystals"**

(73) Proprietor: **Griffiths, Christopher Alan**
**MG 359 Javea**
**Alicante (ES)**

(72) Inventor: **Griffiths, Christopher Alan**
**MG 359 Javea**
**Alicante (ES)**

(74) Representative: **Bryer, Kenneth Robert**
**Hepworth Lawrence & Bryer 1 Strangways**
**Villas**
**Truro Cornwall TR1 2PA (GB)**

(56) References cited:

**1973 IEEE INTERCON TECHNICAL PAPERS, 26th-30th March 1973, pages 1-7, New York, US;**

**E.E. FORSTER: "Automated waveform analysis by computer controlled test systems"**
**EDN, vol. 23, no. 16, 5th September 1978, pages 103-110; D. DEDINAS et al.: "Advanced waveform recorders do more than capture transients"**

Courier Press, Leamington Spa, England.

(56) References cited:

**ELECTRONICS & POWER, vol. 20, no. 20, 14th November 1974, pages 972-974; C.W. FOWLER: "Using a digital memory to record power - line transients"**

**PATENTS ABSTRACTS OF JAPAN, vol. 7, no. 278 (P-242)1423r, 10th December 1983; & JP-A-58 155 364 (SHIOJIRI KOGYO K.K.) 16-09-1983**

## Description

The present invention relates to a combined information recording and graphic display device, and in particular is intended to serve electronically the function until now performed by instruments known as "chart recorders".

Chart recorders are used throughout industry to provide a permanent record of a varying electrical signal. Such electrical signal is converted, upon being fed to the recorder, to cause displacement of a chart marking instrument such as a pen, which is displaceable in a line across the chart whilst the chart itself is displaced, perpendicularly with respect to the line of movement of the pen, at a constant rate or incrementally in dependence on the circumstances. The combined effect of the movement of the pen or other marking instrument, which represents the value of the input signal at any instant in time, and the movement of the paper within the chart recorder, produces a varying line constituting a permanent record of the value of the input signal at any instant in the time period recorded by the instrument. Such permanent records may be required for any one of a number of purposes, for example analysing the past history of variation of a parameter sensed by a suitable sensor and converted into an electrical signal which is supplied to the chart recorder, and may be used for any purpose for analysis, control or prediction.

A major disadvantage with chart recorders is constituted by the sheer bulk of the paper constituting the record of the signal variations. Indeed, given that the chart marking usually constitutes only a single line on a chart of fixed width the major part of the area of the chart is wasted in the sense that it provides no useful information except to constitute a frame of reference within which the value of the signal can be determined.

If the information contained on the chart is likely to be needed again the whole chart must be stored and the storage problems for such bulky objects rapidly becomes a major problem. Access to a given item of information is also difficult since the chart can only be viewed sequentially by "scrolling" through the length of the chart to find a period of interest.

Other disadvantages of known chart recorders are related to their mechanical nature, and therefore the relatively poor response to rapidly fluctuating input signals which limits the high frequency end of the signal spectrum, and to the fact that mechanical disturbances to the recording instrument itself can affect the value of the record thus produced independently of the variations in the input signal thereby introducing another error. Further, the relatively fixed nature of the chart record means that comparison between the signal values at two widely differing points in time can be effected only with difficulty, either by laying the charts out on a large table and physically moving the regions of interest into juxtaposition, or by effecting measurements of the linear dimensions on the chart and storing these separately thereby, again, introducing potential errors in measurement of the chart itself.

The present invention seeks to provide a recording and display instrument capable of performing the same functions as are currently performed by chart recorders, but which will overcome many of the above indicated disadvantages of chart recorders utilising visibly marked papers as the recording medium. The present invention also seeks to provide apparatus which is capable of storing the information electronically and displaying it likewise thereby making it possible to display two or more sections of a signal of interest simultaneously or sequentially in order to effect comparisons.

Further, the present invention seeks to provide a recording and display instrument in which the record of a signal variation over an extended period of time can be stored in a relatively small space avoiding the necessity for large rolls or stacks of paper.

Finally, the present invention seeks to provide an instrument capable of recording and displaying the value of a varying incoming electrical signal utilising only solid state electronic components which are, therefore, not subjet to the perturbing influences of mechanical vibrations or other environmental disturbances. Electronic display apparatus having a certain recording function is disclosed in EP—A—0 066 843. This document describes apparatus comprising means for digitising the value of incoming electrical input signals varying in value with time, a random access memory for storing at successively addressable storage locations the digitised values, and a sold state matrix display device for displaying at least some of the digitised values in graphic form.

According to the present invention, electronic recording and display apparatus is characterised in that the said digitising means includes means for converting the input signals to pulse form, and integration means for integrating the pulses over a period of time, whereby a digitised value representing the mean value of the input signals over said period of time is periodically produced, and the solid state matrix display is controlled by display control means operable to select from the random access memory chosen sets of successive digitised values for application to the solid state matrix display device which is operable to display the individual digitised value by activation of one of a plurality of lines of the display device in such a manner that the magnitude of each digitised value is represented by the length of the corresponding line on the display.

The apparatus of the present invention can thus be used to provide a graphic display of the manner in which an input signal has varied with time in a preceding time period, the individual digitised signal being displayed in such a manner that the magnitude of the digitised signal is represented as a linear dimension on the display.

Of course, the memory may contain a very much greater number of signals than can be displayed at any one time on the display screen, and, therefore, there are preferably provided means for selecting the set of displayed digitised values from the total set of stored values in the memory. An operator may thus choose to display the set of most recent signals, or any set of signals from a period in the past selected by operating, for example, on a keyboard linked to a microprocessor controlling the apparatus.

In a preferred embodiment of the invention the solid state display device is controlled by the apparatus in such a way as to display each digitised signal as a line on the screen, adjacent digitised signals in a set thereof displayed on the screen being displayed as adjacent lines and the length of each line from a given edge of the display screen representing the magnitude of the digitised signal represented thereby.

To further extend the usefulness of the apparatus of the present invention, for example to allow it to provide a permanent record of variation of a signal over a long period, perhaps running into years, there may be further provided permanent storage means, and means for tranferring the information from the memory to the said permanent storage means. Any known permanent storage means suitable for storing sets of electrical signals, and which can be "read" to provide a regeneration of the electrical signals may be employed. For this purpose it is envisaged that the permanent storage means may include a magnetic recording medium such as magnetic tape or magnetic disc, or alternatively, a second solid state memory device may be employed, in which case this is preferably a programmable read-only memory device. Such a memory device is normally hard wired into the circuit and for the purposes of the present invention it is envisaged that the permanent memory would be provided with releasable connections, for example in the form of plug and socket contacts such as the edge contacts frequently provided on printed circuit boards, to allow the memory to be plugged in for transfer of information, and subsequently removed for storage. Non-volatile memory devices are required for this purpose and, if necessary, additional electrical supply by battery incorporated into the modular unit may be provided.

The solid state display device may be a liquid crystal dot matrix display or an electro luminescent display. A graphic display may be generated on such a device, this display being built up from individual visually discernable cells or units. Such a matrix is divided into rows and columns defining a matrix of dots each dot being capable of being electrically energised to provide one of two binary, visually distinguishable states. In a reflective cell the states represent reflective and nonreflective areas such that incident light falling on the screen is selectively reflected to provide a pattern of light and dark areas which can be visually distinguished by an observer. The data stored in the memory is applied to this display device in such a way that a pattern is built up in a manner representative of that displayed on a conventional paper chart recorder. Additionally, means may be provided for displaying at least some of the information in alpha-numeric form, and the information displayed may represent the values of all or some of the signal samples displayed in graphic form on the screen, or may represent values derived therefrom or intermediate values in calculations in which the values of the signal are substituted in order, for example, to determine safety margins or operating conditions. For example, the instantaneous values of each sample displayed graphically on the screen may be summed to provide a separate alpha-numeric display representing the total integral value of the signal over the time period in question, or alternatively an average value may be generated therefrom to represent the mean value of the signal over the display period. Such a mean value may also be indicated graphically either simultaneously or sequentially with the graphic display of the digitised signals.

The display control means referred to above may also be operable to change the display by sequentially adding one signal to one end of the display and removing a signal from the other end of the display, shifting each individual stored signal one unit along the display screen so that an effective "scrolling" through the stored information is achieved. Since the individual digitised signals are stored in a predetermined address pattern in the memory it is possible for the apparatus automatically to display a band of these signals by following the predetermined address pattern.

In addition, the display control means may select a set of values from one location in the memory and another set of values for display from another location in the memory, the display screen then being split to allow two sets of values to be displayed at once for comparison purposes. The screen may be split longitudinally or transversely (in relation to the time axis) for this purpose and, indeed, more than two separate sets of signals may be displayed at any one time if comparison between three or more sets of signals is required.

One embodiment of the present invention will now be more particularly described, by way of example, with reference to the accompanying drawings, in which:

Figure 1 is a block schematic diagram illustrating a circuit constituting an embodiment of the present invention;

Figure 2 is a block diagram representing a part of the circuit of Figure 1; and

Figure 3 is a face view of a screen of a display device forming part of the embodiment of Figure 1.

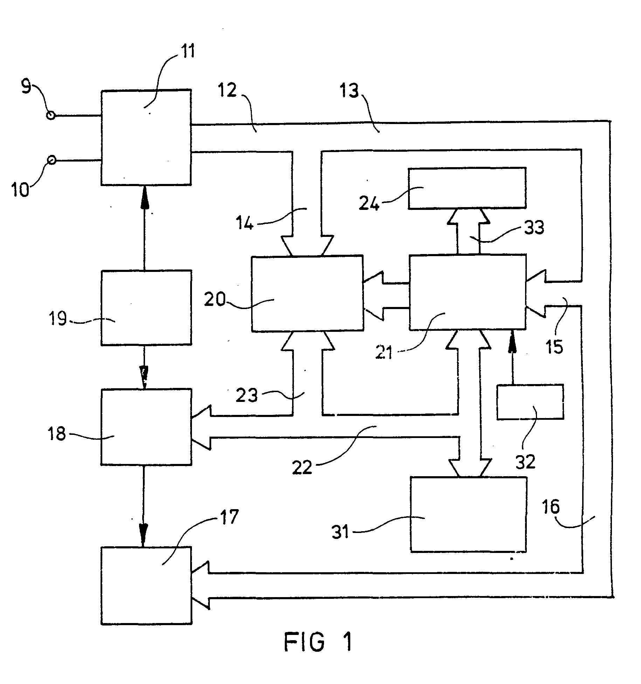

Referring now to Figure 1, the circuit shown is provided with input terminals 9, 10 for receiving an analogue input signal which varies in time. Such signals may, for example, be a voltage signal the value of which varies in dependence on a measured parameter which causes it to vary in time. The nature of the input signal is not, of course, critical to the present invention and adaptation for accepting an electrical signal in which the information is contained in a varying current rather than a varying voltage is equally within the scope of the present invention. Likewise, the source of the signal is unimportant and may come from any type of electrical measuring or signal generating equipment to which a chart recorder may in the past have been attached to provide a display and record of the variations thus manifest.

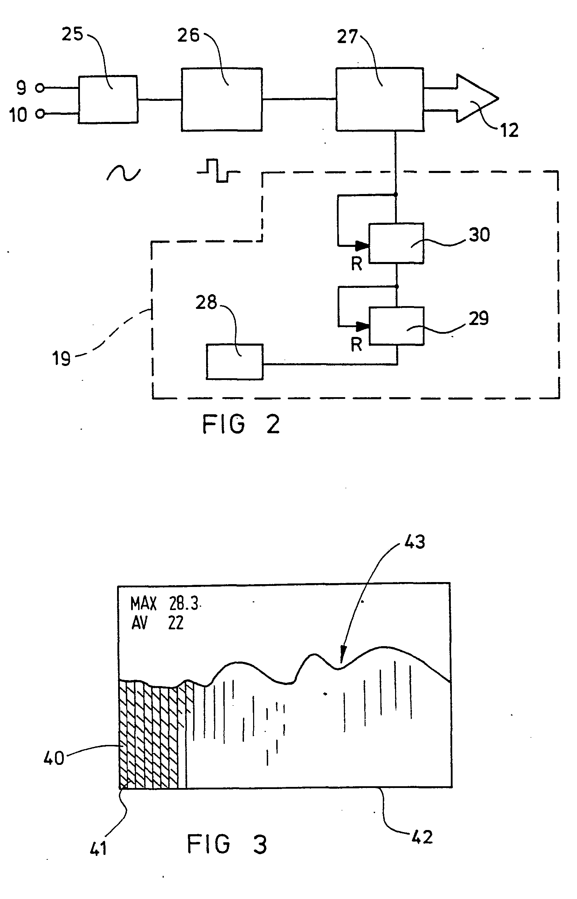

The voltage signal appearing between the terminals 9, 10 is applied to a signal digitiser 11 which will be described in more detail in relation to Figure 2. This signal digitiser receives a timing signal from a time period generator 19 and produces an output signal on a data bus 12 in the form of a digital number of binary form. The data bus 12 may, for example, contain eight lines in which case the digital number emitted by the signal digitiser 11 may vary between 0 and 256. Greater discrimination and definition may be achieved by utilising equipment capable of operating on more than 8-bit digital signals, but for the present description it will be assumed that 8-bit digital number may contain the required information with adequate resolution for the purposes of understanding the way in which the invention operates.

The data bus 12 branches into two parts 13, 14 and the latter branch, 14, leads to a memory 20 whilst the former, 13, branches again into a branch 15 and a branch 16 the former of which leads to a display controller 21 and the latter of which leads to a record/play back circuit 17 which also receives control signals from an address generator 18. The address generator 18 is interconnected with the time period generator 19 and is linked by an address bus 22 to the display controller 21 and by a branching address bus 23 to the memory 20. A further branch of the address bus 22 leads to a permanent record memory 31.

The display controller receives input control signals from a keyboard 32 and generates control signals on an output bus 33 leading to a solid state display device 24 which, as mentioned hereinabove, may be an electroluminescent display or a liquid crystal matrix.

Referring now to Figure 2, the digitisation of the signal appearing across the terminals 9, 10 as an analogue voltage signal is effected by means of a voltage-to-frequency converter 25 which receives the varying input voltage signal and produces a frequency signal at the output thereof which varies in dependence on the magnitude of the input voltage signal. The varying frequency signal from the voltage-to-frequency converter 25 is suppled to a pulse shaper 26 which, by any of the known means, (such as infinite clipping or saturation amplifying) produces a square pulse wave form at its output at the same frequency as the wave form at the input. The square pulses from the pulse shaper 26 are then supplied to a counter 27 which counts for a time period determined by the period generator 19 which, as shown in Figure 2, is itself constituted by an oscillator 28, a first counter 29 the output of which is connected to a second counter 30 and to its own reset input, the output of the counter 30 being connected to its own reset input and to the reset terminal of the counter 27. The oscillator 28 generates a fixed frequency signal which is, in effect, divided down by the counters 29 and 30 to produce an output signal at a fixed period which depends on the required sampling time. This sampling time may be any suitable time period for the purposes to which the recording instrument of the present invention is put and may vary from merely seconds in some situations to minutes, hours or even weeks in others. For example, in the present description the time period will be assumed to be one minute. The counter 27 will thus produce an output to the data bus 12 representing the number of input pulses which it has counted during the preceding minute and is then reset by the time period generator 19 which latter then commences to time the next one minute period. The output from the counter 27 is in the form of an 8-bit binary number supplied to the memory 14 and stored there in an address determined by the address generator 18 which is also controlled by the time period generator 19 so that each individual 8-bit number arriving on the branch 14 of the data bus 12 is directed to an individual separate address by the address generator 18 until the memory 20 is full. When this happens the future operation of the circuit depends on the programme in the display controller 21. If a long term store of the information is not required the address generator 18 may merely cycle through the address locations in the memory 20, starting again with the first address location when the last has been filled so that the device only contains information pertinent to a fixed preceding time period and is continually updated. Alternatively, if a permanent record is required, the display controller 21 detects when the last memory location is filled in the memory 20 and triggers the record/playback circuit 17 to cause the memory 20 to unload its contents into a permanent record 31. As explained above this permanent record may be in the form of a magnetic disc of known type, a magnetic tape or a programmable read-only memory. In the case of the programmable memory this is held in a casing having releasable terminals such as plug and socket connections enabling it to be removed easily for storage and replaced by a similar memory for storing the next set of signals.

The display on the display device 24 is representative of a fixed size set of signals within the memory, and represents a "field of view" determined by the maximum number of matrix elements from which such a display device may be made. The physical dimensions of the apparatus and the required resolution of the signal will also determine the number of individual digitised signals which may be displayed on the screen. Figure 3 illustrates the format in which the screen image appears, this representing a plurality of dark columns 40, 41, etc., the length of which from the edge 42 of the screen represents the position of a line 42 constituting an indication of variation in the value of the incoming signal applied to the terminals 9, 10. In addition, on the screen, alpha-numeric representation of selected signals and calculations made from the values of these signals may be displayed. In Figure 3 the alpha-numeric display represents the maximum value, that is the value of greatest signal displayed, and the "average" value of the signals displayed. It will be apparent to those skilled in the art how other alpha-numeric signals representative of any desired combination of the stored signals or calculations based on the values of these stored signals may be made.

## Claims

1. Electronic recording and display apparatus comprising means (11) for digitising the value of incoming electrical input signals varying in value with time, a random access memory (20) for storing at successively addressable storage locations the digitised values, and a solid state matrix display device (24) for displaying at least some of the digitised values in graphic form, characterised in that the said digitising means (11) includes means (25, 26) for converting the input signals to pulse form, and integration means (27) for integrating the pulses over a period of time, whereby a digitised value representing the mean value of the input signals over said period of time is periodically produced, and the solid state matrix display (24) is controlled by display control means (21) operable to select from the random access memory (20) chosen sets of successive digitised values for application to the solid state matrix display device (24) which is operable to display the individual digitised value by activation of one of a plurality of lines of the display device in such a manner that the magnitude of each digitised value is represented by the length of the corresponding line on the display (24).

2. Electronic recording and display apparatus according to Claim 1, characterised in that the solid state display device (24) is a liquid crystal matrix display, or an electroluminescent display.

3. Electronic recording and display apparatus according to Claim 1 or Claim 2, characterised in that the said display control means (21) for controlling display of a selected plurality of digitised signals from the memory is selectively operative to change the set of displayed signals by one to the signal stored in the adjacent address location in the memory (20) after each set has been displayed for a predetermined time whereby to effect apparent "scrolling" through the stored information.

4. Electronic recording and display apparatus according to Claim 3, characterised in that the display control means (21) is operative to display two or more sets of digitised signals selected from the signals stored at different address locations in the memory (20) whereby to effect a comparison display on the display device (24).

5. Electronic recording and display apparatus according to any preceding Claim, characterised in that the display controller (21) is further selectively operable to cause the display device (24) to display data representing the numerical values of the digitised input signals and/or the value of other signals derived therefrom in addition to or in place of the graphic display of the digitised signal variation, this data display being in the form of alpha-numeric characters.

6. Electronic recording and display apparatus according to any preceding Claim, characterised in that the programmable read only memory is provided with releasable electrical terminals whereby the memory device (31) can be removed and replaced periodically so as to provide a permanent reproducible record of the data over the recording time period for which it is in position.

7. Electronic recording and display apparatus according to any preceding Claim, characterised in that the said solid state matrix display device displays a plurality of adjacent columns (40, 41) on the screen, the order of the said columns (40, 41) corresponding to the order of said successive digital values, and the length of each column (40, 41) from a given edge (42) of the screen representing the magnitude of the said digitised value.

## Patentansprüche

1. Elektronisches Aufzeichnungs- und Wiedergabegerät mit
—Mitteln (11) zum Digitalisieren des Wertes ankommender elektrischer Eingangssignale, deren Werte zeitveränderlich sind
—einem Randomspeicher (20) zum Abspeichern der digitalisierten Werte in aufeinanderfolgend addressierbaren Speicherplätzen,
—einer Halbleiter-Matrixanzeigevorrichtung (24) zur Wiedergabe wenigstens einiger der dititalisierten Werte in graphischer Form,
dadurch gekennzeichnet, daß die Digitalisiermittel (11) Mittel (25, 26) zum Umwandeln der Eingangssignale in Pulsform und Integrationsmittel (27) zum Integrieren der Pulse über einen Zeitraum aufweisen, wodurch ein dititalisierter Wert, der den Mittelwert der Eingangssignale über den genannten Zeitraum repräsentiert, periodisch erzeugt wird und die Halbleiter-Matrixanzeiger (24) von einem Anzeigesteuermittel (21) gesteuert wird, das aus dem Randomspeicher (20) ausgewählte Sätze von aufeinanderfolgenden digitalisierten Werten auswählen kann für die Weiterleitung zu der Halbleiter-Matrixanzeigevorrichtung (24), die die einzelnen digitalisierten Werte durch Aktivierung einer von vielen Zeilen des Anzeigevorrichtung darstellen kann, so daß die Größe jedes digitalisierten Wertes dargestellt wird durch die Länge der entsprechenden Zeile auf der Anzeige (24).

2. Elektronisches Aufzeichungs- un Wiedergabegerät nach Anspruch 1, dadurch gekennzeichnet, daß die Halbleiter-Anzeigevorrichtung (24) eine Flüssigkeits-Matrixanzeige oder eine Leuchtanzeige ist.

3. Gerät nach Anspruch 1 oder 2, dadurch gekennzeichnet, daß das Anzeigesteuermittel (21) zum Steuern der Anzeige einer ausgewählten Anzahl von digitalisierten Signalen aus dem Speicher selektiv betrieben wird, um den Satz angezeigter Signale durch eines der Signale zu verändern, die in benachbarten Speicherplätzen im Speicher (20) abgelegt sind, nachdem jeder Satz für eine vorbestimmte Zeit angezeigt worden ist, wodurch ein scheinbares "Scrollen" durch die gespeicherte Information bewirkt wird.

4. Gerät nach Anspruch 3, dadurch gekennzeichnet, daß das Anzeigesteuermittel (21) betrieben wird, um zwei oder mehrere Sätze von digitalisierten Signalen anzuzeigen, die aus Signalen ausgewählt werden, die an verschiedenen Speicherplätzen im Speicher (20) abgelegt sind, wodurch eine Vergleichsanzeige auf der Anzeigevorrichtung (24) bewirkt wird.

5. Gerät nach einem der vorhergenden Ansprüche, dadurch gekennzeichnet, daß das Anzeigesteuermittel (21) desweiteren selektiv betrieben werden kann, um die Anzeigevorrichtung (24) zur Anzeige von Daten zu veranlassen, welche die numerischen Werte der digitalisierten Eingangssignale und/oder der Wert anderer Signale repräsentieren, die davon zusätzlich zu oder anstelle der graphischen Anzeige der Veränderung der digitalisierten Signale in Form von alphanumerischen Zeichen vonstatten geht.

6. Gerät nach einem der vorhergehenden Ansprüche, dadurch gekennzeichnet, daß der programmierbare Festwertspeicher ausgestattet mit freigebbaren elektrischen Anschlüssen ist, wodurch das Speichergerät (31) entfernt und periodisch ersetzt werden kann, um einer permanent reproduzierbare Aufzeichnung der Daten über den Aufnahmezeitraum zu gestalten, für den es in Lage ist.

7. Gerät nach einem der vorhergehenden Ansprüche, dadurch gekennzeichnet, daß die Halbleiter-Matrixanzeigevorrichtung eine Anzahl von benachbarten Spalten (40, 41) auf dem Bildschirm aufweist, wobei die Ordnung der Spalten (40, 41) mit der Ordnung aufeinanderfolgender Digitalwerte korrespondiert und wobei die Länge jeder Spalte (40, 41) von einer gegebenen Kante (42) des Schirmes die Größe des digitalisierten Wertes repräsentiert.

**Revendications**

1. Appareil d'enregistrement et d'affichage électronique comprenant un moyen (11) pour numériser la valeur des signaux d'entrée électrique entrant variant en valeur dans le temps, une mémoire à accès aléatoire (20) pour mémoriser à des emplacements de stockage successivement adressables les valeurs numérisées et un dispositif d'affichage matriciel à l'état solide (24) pour afficher au moins un certain nombre des valeurs numérisées sous forme graphique, caractérisé en ce que ledit moyen de numérisation (11) comprend un moyen (25, 26) pour convertir les signaux d'entrée en forme d'impulsion et un moyen d'intégration (27) pour intégrer les impulsions sur une période de temps, permettant qu'une valeur numérisée représentant le valeur moyenne des signaux d'entrée sur ladite période de temps soit produite périodiquement et en ce que l'affichage matriciel à l'état solide (24) est commandé par un moyen de commande d'affichage (21) pouvant être commandé pour sélectionner à partir de la mémoire à accès aléatoire (20) des ensembles choisis de valeurs numérisées successives pour application au dispositif d'affichage matriciel à l'état solide (24) qui peut être commandé pour afficher les valeurs numérisées individuelles par activation de l'une d'une pluralité de lignes du dispositif d'affichage d'une manière telle que la grandeur de chaque valeur numérisée est représentée par la longueur de la ligne correspondante sur l'affichage (24).

2. Appareil d'enregistrement et d'affichage électronique selon la revendication 1, caractérisé en ce que, le dispositif d'affichage à l'état solide est un affichage matriciel à cristaux liquides ou un affichage électroluminescent.

3. Appareil d'enregistrement et d'affichage électronique selon la revendication 1 ou 2, caractérisé en ce que ledit moyen de commande d'affichage (21) pour commander l'affichage d'une pluralité sélectionnée de signaux numérisés provenant de la mémoire est sélectivement actif pour remplacer l'ensemble de signaux affichés par un en le signal mémorisé dans l'emplacement d'adresse adjacent dans la mémoire (20) après que chaque ensemble a été affiché pendant un temps prédéterminé, ainsi permettant d'effectuer un "défilement" apparent de toutes les information mémorisées.

4. Appareil d'enregistrement t d'affichage électronique selon la revendication 3, caractérisé en ce que le moyen de commande d'affichage (21) peut être commandé pour afficher deux ou plus ensemble de signaux mumérisés sélectionnés à partir de signaux mémorisés en des emplacements d'adresse différents dans la mémoire (20) permettant d'effecteur un affichage de comparaison sur le dispositif d'affichage (24).

5. Appareil d'enregistrement et d'affichage électronique selon l'une quelconque des revendications précédentes, caractérisé en ce que le contrôleur d'affichage (21) peut en outre être sélectivement commandé pour amener le dispositif d'affichage (24) à afficher des données représentant les valeurs numériques des signaux d'entrée numérisés et/ou la valeur d'autres signaux obtenus à partir de ceux-ci en plus de ou au lieu de l'affichage graphique de la variation des signaux numérisés, cet affichage de données se faisant sous forme de caractères alpha-numériques.

6. Appareil d'enregistrement et d'affichage électronique selon l'une quelconques des revendications précédentes, caractérisé en ce que la

mémoire morte programmable est pourvue de bornes électroniques détachables qui peuvent être enlevées et replacées périodiquement de façon à permettre un enregistrement reproductible permanent des données sur la période de temps d'enregistrement pour laquelle il est en position.

7. Appareil d'enregistrement et d'affichage électronique selon l'une quelconque des revendications précédentes, caractérisé en ce que ledit dispositif d'affichage matriciel à l'état solide affiche une pluralité de colonnes adjacentes (40, 41) sur l'écran, l'ordre desdites colonnes correspondant à l'ordre desdites valeurs numériques successives et la longueur de chaque colonne (40, 41) à partir d'un bord donné (42) de l'écran représentant la grandeur de ladite valeur numérisée.

FIG 1

EP 0 165 036 B1

FIG 2

MAX 28.3
AV 22

FIG 3